# EUROPÄISCHE PATENTSCHRIFT

(11) **EP 1 726 922 B1**
(45) Veröffentlichungstag und Bekanntmachung des Hinweises auf die Patenterteilung: **12.02.2014**
(21) Anmeldenummer: 06008606.3
(22) Anmeldetag: 26.04.2006
(51) Int. Cl.: G01F 23/284, G01S 13/32, G01R 19/25

(54) **Abtastschaltung**
Scanning circuit
Circuit d'échantillonnage

(30) Priorität: 25.05.2005 DE 102005024643
(43) Veröffentlichungstag der Anmeldung: 29.11.2006
(73) Patentinhaber: Krohne S.A., 26103 Romans - Cedex (FR)
(72) Erfinder: Gerding, Michael, 44623 Herne (DE); Schiek, Burkhard, 44801 Bochum (DE); Musch, Thomas, 45481 Mülheim an der Ruhr (DE)
(74) Vertreter: Gesthuysen, Hans Dieter

(56) Entgegenhaltungen:
- EP-A- 0 037 258
- DE-A1- 4 237 925
- US-A- 4 308 468
- US-A- 5 170 075
- US-A- 5 465 411
- US-A- 5 517 140
- US-A- 6 084 440

## Beschreibung

Die Erfindung betrifft eine Abtastschaltung zur sequentiellen Abtastung eines breitbandigen, periodischen Eingangssignals, wobei ein nichtlineares Bauelement vorgesehen ist, dem ein impulsförmiges Abtastsignal zugeführt wird, wodurch die Abtastung aktiviert wird, so daß ein Ausgangssignal erzeugt wird, wobei als nichtlineares Bauelement ein Feldeffekttransistor vorgesehen ist, wobei die Auskopplung des Ausgangssignals am Drain-Kontakt des Feldeffekttransistors vorgesehen ist, wobei die Einspeisung des Eingangssignals am Drain-Kontakt des Feldeffekttransistors vorgesehen ist, wobei die Einspeisung des Eingangssignals von der Auskopplung des Ausgangssignals mittels einer Filteranordnung getrennt ist und wobei die Einspeisung des Abtastsignals am Gate-Kontakt des Feldeffekttransistors vorgesehen ist.

Eine gattungsgemäße Schaltung lässt sich der Patentschrift US 6,084,440 A entnehmen, die Methoden zur Löschung von harmonischen Störungen in Sample-and-Hold-Schaltungen offenbart.

Die Erfassung eines breitbandigen Signals bzw. eines sich zeitlich schnell ändernden Signalverlaufs läßt sich mittels direkter Echtzeitabtastung gar nicht oder nur unter sehr großem technischen Aufwand realisieren. Ein typischer Anwendungsfall ist die Füllstandsmessung mittels eines Puls-Radars, wobei die technische Schwierigkeit darin liegt, die Laufzeit des Radar-Signals sehr genau zu messen. Für eine Abstandsmeßgenauigkeit von 1 mm ist nämlich eine Genauigkeit der Zeitmessung von etwa 6 ps erforderlich. Eine mögliche Alternative zur direkten Echtzeitabtastung stellt eine sequentielle Abtastung dar. Die sequentielle Abtastung kommt mit einer deutlich geringeren Abtastrate aus, ist jedoch ausschließlich auf die Anwendung bei periodischen Signalen beschränkt. Im Gegensatz zur Echtzeitabtastung wird dabei pro Signalperiode nur ein Abtastwert aufgenommen. Anschließend wird das schnelle, abzutastende Signal aus einer Vielzahl einzelner Abtastpunkte rekonstruiert. Da dieses Abtastverfahren eine Frequenzumsetzung des Eingangssignals zur Folge hat, läßt sich dieser Vorgang auch als Oberwellenmischung deuten.

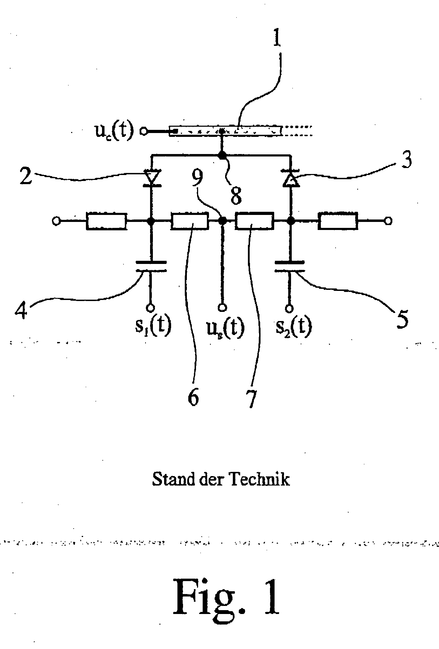

Eine herkömmliche Realisierung einer Abtast- bzw. Sampling-Schaltung ist in Fig. 1 dargestellt. Ein abzutastendes Eingangssignal wird über eine Sende- und Empfangsleitung 1 auf zwei antiparallel angeordnete Schaltdioden 2, 3 geführt. Die beiden antiparallel angeordneten Schaltdioden 2, 3 werden im Ruhezustand durch eine jeweils angelegte DC-Vorspannung zunächst in richtung betrieben. Während des eigentlichen Abtastvorgangs schalten ein impulsförmiges Abtastsignal s₁ (t) und ein dazu inverses Abtastsignal s₂ (t) die Schaltdioden 2, 3 leitend, so daß die Strecke zwischen der Einspeisung des abzutastenden Eingangssignals u_{c} (t) und zwei den Schaltdioden 2, 3 jeweils nachgeschalteten Abtastkondensatoren 4, 5 für eine kurze Zeit niederohmig werden. Der Ladungsanteil auf den Abtastkondensatoren 4, 5, der von den impulsförmigen Abtastimpulsen herrührt, kann sich über Widerstände 6, 7 entladen. Unter der Voraussetzung, daß die Abtastkondensatoren 4, 5 zwischen zwei Abtastvorgängen vollständig entladen werden, ergeben sich die Abtastpunkte des abgetasteten Eingangssignals prinzipiell aus der über den Abtastkondensatoren 4, 5 anstehenden mittleren Spannung uₛ (t). Gilt zwischen den beiden Abtastsignalen der Zusammenhang s₁ (t) = -s₂ (t), so lassen sich die Knoten 8, 9 bezüglich dieser Signale als virtuelle Massepunkte ansehen. Folglich heben sich im Idealfall die Abtastsignale an diesen Knoten 8, 9 gegenseitig auf, so daß ein Übersprechen der Abtastsignale in den Zwischenfrequenzpfad und den Signalpfad unterbunden wird, womit eine Balancierung der Schaltung erzielt wird.

Nachteilig bei dieser herkömmlichen Lösung sind unter anderem die extremen Anforderungen an den Phasen- und Amplitudenverlauf der beiden zueinander inversen Abtastsignale wie sie für eine funktionierende Balancierung erforderlich sind. Für die Gewährleistung der Balancierung müssen die beiden Abtastsignale dem Betrag nach identisch sein und gleichzeitig um genau 180° gedrehte Phasen aufweisen, was die Erzeugung dieser Signale entsprechend aufwendig werden läßt bzw. die Funktionsweise der Schaltung anfällig für Bauteiltoleranzen macht.

Ausgehend von dieser Problematik ist es die Aufgabe der Erfindung, eine derartige Schaltung anzugeben, die kostengünstig, technisch robust und vielseitig sowie einfach anwendbar ist.

Ausgehend von der eingangs beschriebenen Abtastschaltung zur sequentiellen Abtastung eines breitbandigen, periodischen Eingangssignals ist diese Aufgabe dadurch gelöst, daß auf der Seite der Einspeisung ein Hochpaßfilter und auf der Seite der Auskopplung ein Tiefpaßfilter vorgesehen ist.

Erfindungsgemäß wird also ein Feldeffekttransistor verwendet, um die Abtastung zu aktivieren, also bei anliegendem impulsförmigen Abtastsignal das abzutastende Eingangssignal zu erfassen, um damit als abgetastetes Signal das Ausgangssignal zu erzeugen. Dabei gilt, daß Feldeffekttransistoren eine inhärente Entkopplung zwischen Gate und Drain aufweisen, so daß bei geeigneter Beschaltung des Feldeffekttransistors das Abtastsignal weder in den Signalpfad noch in den Zwischenfrequenzpfad einspricht. Ein weiterer Vorteil einer Abtastschaltung mit einem Feldeffekttransistor liegt in der inhärenten Rauschbalancierung, da das am Gate anliegende Signal nicht gleichgerichtet wird.

Insgesamt erhält man also eine inhärente Entkopplung von Ansteuersignal und Ausgangssignal bei inhärenter Rauschbalancierung der Abtastschaltung. Durch die Auswahl unterschiedlicher Typen von Feldeffekttransistoren (n-Kanal/p-Kanal) ergeben sich weitere Freiheitsgrade bezüglich der Polarität der unipolaren Abtastimpulse und der Realisierung unterschiedlicher Ausgangsimpedanzen für das abgetastete Eingangssignal.

Ganz besonders bevorzugt ist ein mehrstufiger LC-Filter mit magnetisch abgeschirmten Induktivitäten.

Im einzelnen gibt es nun eine Vielzahl von Möglichkeiten, die erfindungsgemäße Abtastschaltung zur sequentiellen Abtastung eines breitbandigen, periodischen Eingangssignals auszugestalten und weiterzubilden. Dazu wird auf den dem Patentanspruch 1 nachgeordneten Patenanspruch sowie auf die nachfolgende detaillierte Beschreibung eines Ausführungsbeispiels der Erfindung unter Bezugnahme auf die Zeichnung verwiesen. In der Zeichnung zeigt
- Fig. 1: ein Prinzipschaltbild einer auf antiparallel geschalteten Dioden basierenden herkömmlichen Abtastschaltung,
- Fig. 2: ein Prinzipschaltbild einer Abtastschaltung gemäß einem bevorzugten Ausführungsbeispiel der Erfindung,
- Fig. 3: ein Prinzipschaltbild einer Abtastschaltung gemäß einem nicht erfindungsgemäßen Ausführungsbeispiel und
- Fig. 4: eine Abtastschaltung gemäß einem weiteren, nicht erfindungsgemäßen Ausführungsbeispiel.
Die im folgenden beschriebenen Abtastschaltungen gemäß bevorzugter Ausführungsbeispiele der Erfindung weisen jeweils GaAs-Sperrschicht-Feldeffekttransistoren mit Schottky-Kontakt auf, die passiv, d. h. ohne die Vorgabe einer Drain-Source-Spannung, betrieben werden. Neben sehr guten Großsignaleigenschaften läßt sich auf diesem Weg eine absolute Stabilität der Schaltung erzielen. Die eigentliche Abtastung bzw. die Frequenzumsetzung eines breitbandigen Eingangssignals u_{c} (t) auf ein schmalbandiges Zwischenfrequenzsignal uₛ (t) erfolg durch die Aussteuerung des nichtlinearen spannungsabhängigen Drain-Source-Kanalwiderstands mittels eines impulsförmigen Abtastsignals s (t).

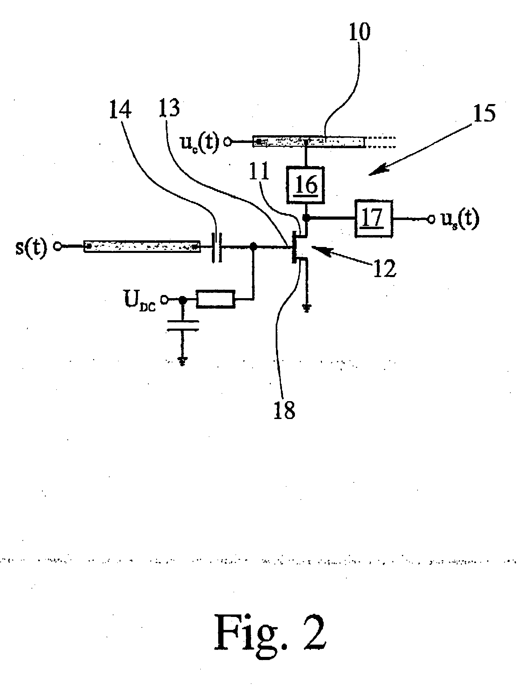

Aus Fig. 2 ist nun eine Abtastschaltung gemäß einem bevorzugten Ausführungsbeispiel der Erfindung ersichtlich. Über eine Sende- und Empfangsleitung 10 wird der Abtastschaltung das abzutastende Eingangssignal zugeführt. Die Einkopplung des abzutastenden Eingangssignals erfolgt über den Drain-Kontakt 11 eines Feldeffekttransistors 12. Ein Abtastsignal s (t) wird auf das Gate 13 des Feldeffekttransistors 12 gegeben. In Kombination mit einer angelegten DG-Vorspannung U_{DC} steuert das Abtastsignal damit periodisch den Kanalwiderstand der Drain-Source-Strecke, womit der Arbeitspunkt für das abzutastende Eingangssignal u_{c} (t) bestimmt wird. Der DC-Arbeitspunkt des Feldeffekttransistors 12 wird in der Regel über die am Gate-Kontakt 13 angelegte Vorspannung derart gewählt, daß in Kombination mit dem über einen Kondensator 14 zugeführten Abtastsignal die Aussteuerung des Kanals zwischen geschlossenem und offenem Kanal erfolgt.

Weiterhin läßt sich durch die Wahl der DC-Vorspannung und der Polarität der Impulse des Abtastsignals in Kombination mit der Kanaldotierung des Feldeffekttransistors 12 die zeitlich mittlere Impedanz der Drain-Source-Strecke und damit die Ausgangsimpedanz der Schaltung bestimmen. Wird das Gate 13 des Feldeffekttransistors 12 bei einem n-dotierten Kanal beispielsweise negativ vorgespannt und wird die Polarität des Abtastsignals positiv gewählt, so ist die Drain-Source-Strecke nur während der Dauer der kurzen Impulse des Abtastsignals niederohmig und damit im zeitlichen Mittel hochohmig, und zwar vorliegend im Bereich von einigen Kiloohm.

Andererseits bewirkt eine leicht positive DC-Vorspannung in Kombination mit negativen Impulsen des Abtastsignals im zeitlichen Mittel eine relativ niederohmige Impedanz der Drain-Source-Strecke im Bereich weniger Ohm. Die Polaritätswahl der Ansteuerung der Schaltung und die damit verbundene Bestimmung der Ausgangsimpedanz nimmt nicht unmittelbar Einfluß auf die Leistungsfähigkeit der Schaltung, sondern richtet sich vielmehr nach der vorgesehenen Anwendung. Eine Realisierung mit einer niederohmigen Ausgangsimpedanz ermöglicht beispielsweise trotz einer eventuell geforderten DC-gekoppelten Auskopplung des Zwischenfrequenzsignals ein annähernd DC-freies Ausgangssignal, da sich über dem niederohmigen Kanalwiderstand keine Speicherladung aufbauen kann, die anschließend dem Zwischenfrequenzsignal als DC-Anteil überlagert wäre.

Die Einspeisung des abzutastenden Eingangssignals u_{c} (t) und die Auskopplung des abgetasteten Signals, also des Ausgangssignals uₛ (t) erfolgen am Drain-Kontakt 11 des Feldeffekttransistors 12. Dabei sind die beiden Signale durch eine Filteranordnung 15 voneinander getrennt. Auf der Seite der Einspeisung des Eingangssignals ist nämlich ein Hochpaßfilter 16 und auf der Seite der Auskopplung des abgetasteten Signals ist ein Tiefpaßfilter 17 vorgesehen. Hier bietet sich die Verwendung eines mehrstufigen LC-Filters an, der ausschließlich magnetisch abgeschirmte Induktivitäten aufweist, um eine eventuelle magnetische Einkopplung an diesem Schaltungspunkt zu unterbinden.

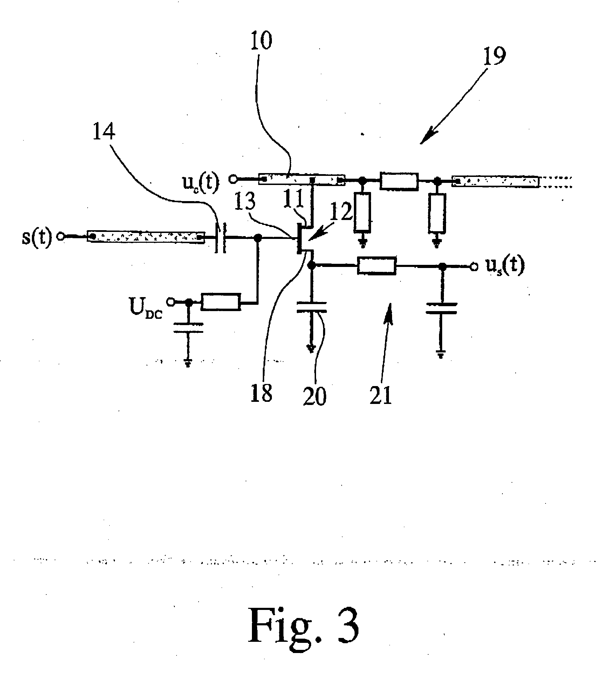

Aus Fig. 3 ist nun eine Abtastschaltung gemäß einem nicht erfindungsgemäßen Ausführungsbeispiel ersichtlich. Durch eine geringe Modifikation der Struktur der Schaltung im Vergleich zum bevorzugten Ausführungsbeispiel der Erfindung lassen sich die erforderlichen Filtermaßnahmen zur Trennung des Eingangssignals vom Ausgangssignal weiter vereinfachen. Während der Drain-Kontakt 11 des Feldeffekttransistors 12 ohne einen Filter direkt im Sende- und Empfangspfad liegt, ist der Abgriff des Ausgangssignals am Source-Kontakte 18 des Feldeffekttransistors 12 vorgegehen. Bei diesem nicht erfindungsgemäßen Ausführungsbeispiel ist in die Sende- und Empfangsleitung ein H-Dämpfungsglied 19 eingebaut, das der Verbesserung der Eingangsanpassung der Schaltung dient.

Werden, wie zuvor beschrieben, die Vorspannung am Gate 13 des Feldeffekttransistors 12 negativ gewählt und die Polarität der Impulse des Abtastsignals positiv, so wird für die Dauer eines Impulses des Abtastsignals der Kanalwiderstand der Drain-Source-Strecke niederohmig, so daß ein an den Source-Kontakt 18 angeschlossener Speicherkondensator 20 auf einen Bruchteil der Momentanspannung von u_{c} (t) aufgeladen wird. Für die restliche Zeit einer Abtastperiode ist der Kanal hochohmig, so daß der Zwischenfrequenzabgriff vom abzutastenden Eingangssignal u_{c} (t) isoliert ist. Zur weiteren Unterdrükkung der dennoch dem Zwvischenfrequenzsignal am Source-Kontakt überlagerten geringen höherfrequenten Signalanteile dient eine einfache RC-Filterkette 21. Bei RC-Filtern ist dabei vorteilhaft, daß diese im Gegensatz zu LC-Filtern unempfindlich gegenüber magnetischer und elektrischer Einstrahlung sind, so daß die Einkopplung nichtkohärenter Signale verhindert wird.

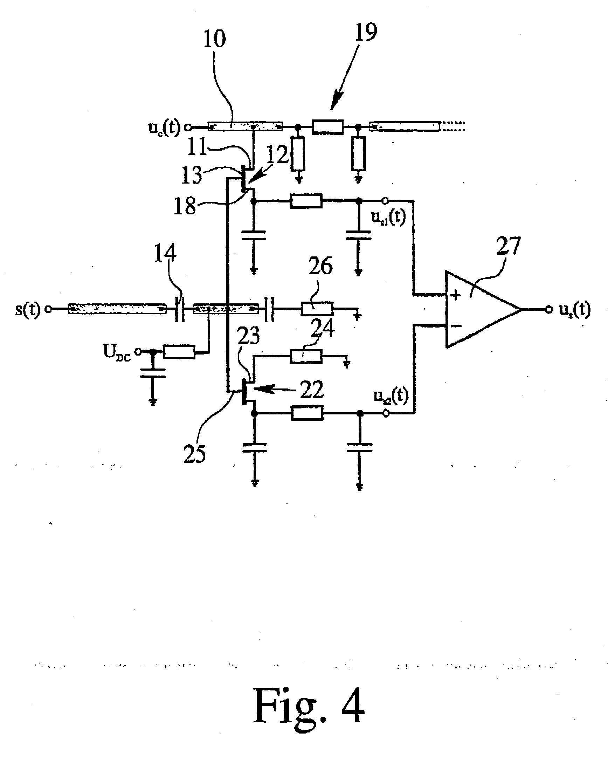

Aus Fig. 4 ist schließlich eine Abtastschaltung gemäß einem weiteren, nicht erfindungsgemäßen Ausführungsbeispiel beschrieben. Dabei handelt es sich quasi um eine Erweiterung der aus Fig. 3 ersichtlichen Schaltung, wobei ein zusätzlicher Feldeffekttransistor 22 vorgesehen ist. Diese Schaltung mit zwei Feldeffekttransistoren 12, 22 setzt sich aus zwei identisch aufgebauten Einzelschaltungen zusammen, wobei das Ausgangssignal der gesamten Schaltung aus der Differenz der Zwischenfrequenzsignale der beiden Einzelschaltungen gebildet wird, wozu ein Differenzverstärker 27 vorgesehen ist. Die obere Einzelschaltung der gesamten Schaltung gemäß dem Ausführungsbeispiel aus Fig. 4 entspricht der zuvor beschriebenen Schaltung aus Fig. 3. Der Feldeffekttransistor 22 der unteren Schaltung ist jedoch als "Dummy" beschaltet. Das heißt, daß der Drain-Kontakt 23 des zusätzlichen Feldeffekttransistors 22 mit einer Impedanz 24 belastet ist, die identisch zu der Lastimpedanz ist, durch die der Feldeffekttransistor 12 am Drain-Kontakt 11 durch den Signalpfad belastet ist.

Zusätzlich zur identischen lastseitigen Beschaltung der Feldeffekttransistoren 12, 22 werden beide Schaltungen mit demselben Abtastsignal und derselben Gate-Vorspannung angesteuert. Anschaulich dargestellt heißt das, daß die Impulse des Abtastsignals über die beiden Gates 13, 25 der Feldeffekttransistoren 12, 22 hinweglaufen und mit einer Abschlußimpedanz 26 reflektionsfrei abgeschlossen sind. Durch die identische Beschaltung und Ansteuerung der beiden Feldeffekttransistoren 12, 22 ergeben sich auch die Gleichanteile in den Zwischenftequenzsignalen uₛ₁ (t) und uₛ₂ (t) einer jeden Schaltung ebenfalls identisch, so daß sich aus der Differenz uₛ₁ (t) - uₛ₂ (t) das DC-freie Zwischenfrequenzsignals uₛ (t) ergibt.

## Patentansprüche

1. Abtastschaltung zur sequentiellen Abtastung eines breitbandigen, periodischen Eingangssignals, wobei ein nichtlineares Bauelement vorgesehen ist, dem ein impulsförmiges Abtastsignal zugeführt wird, wodurch die Abtastung aktiviert wird, so dass ein Ausgangssignal erzeugt wird, wobei als nichtlineares Bauelement ein Feldeffekttransistor (12) vorgesehen ist, wobei die Auskopplung des Ausgangssignals am Drain-Kontakt (11) des Feldeffekttransistors (12) vorgesehen ist, wobei die Einspeisung des Eingangssignals am Drain-Kontakt (11) des Feldeffekttransistors (12) vorgesehen ist, wobei die Einspeisung des Eingangssignals von der Auskopplung des Ausgangssignals mittels einer Filteranordnung (15) getrennt ist und wobei die Einspeisung des Abtastsignals am Gate-Kontakt (13) des Feldeffekttransistors (12) vorgesehen ist,
**dadurch gekennzeichnet,**
**daß** auf der Seite der Einspeisung ein Hochpaßfilter (16) und auf der Seite der Auskopplung ein Tiefpaßfilter (17) vorgesehen ist.

2. Abtastschaltung nach Anspruch 1, **dadurch gekennzeichnet, daß** ein mehrstufiger LC-Filter mit magnetisch abgeschirmten Induktivitäten vorgesehen ist.

## Claims

1. Sampling circuit for sequential sampling of a broadband periodic input signal, wherein a nonlinear component is provided to which a pulsed-shaped sampling signal is supplied, by which sampling is activated so that an output signal is produced, wherein a field effect transistor (12) is provided as nonlinear component, wherein an output signal is decoupled at a drain contact (11) of the field effect transistor (12), wherein an input signal feed is provided at a drain contact (11) of the field effect transistor (12), wherein input signal feed is separated from decoupling of the output signal by means of a filter arrangement (15) and wherein a sampling signal feed is provided at the gate contact (13) of the field effect transistor (12),
**characterized in**
**that** a high-pass filter is provided on a feed side and a low-pass filter is provided on a decoupling side.

2. Sampling circuit according to claim 1, **characterized in that** a multi-stage LC filter with magnetically shielded inductances is provided.

## Revendications

1. Circuit de balayage servant au balayage séquentiel d'un signal d'entrée périodique à large bande, un signal de balayage en forme d'impulsion étant amené à un composant non linéaire prévu, activant ainsi le balayage, de façon à produire un signal de sortie, un transistor à effet de champ (12) servant de composant non linéaire, le découplage du signal de sortie étant réalisé au niveau du contact de drain (11) du transistor à effet de champ (12), l'entrée du signal d'entrée étant prévue au niveau du contact de drain (11) du transistor à effet de champ (12), l'entrée du signal d'entrée étant séparée du découplage du signal de sortie à l'aide d'un agencement de filtrage (15) et l'entrée du signal de balayage étant prévue au niveau du contact de grille (13) du transistor à effet de champ (12), **caractérisé en ce qu'**un filtre passe-haut (16) est prévu du côté de l'entrée et qu'un filtre passe-bas (17) est prévu du côté du découplage.

2. Circuit de balayage selon la revendication 1, **caractérisé en ce qu'**un filtre LC à plusieurs étages doté d'inductivités à blindage magnétique est prévu.
